# EUROPEAN PATENT SPECIFICATION

(11) **EP 3 947 500 B1**
(45) Date of publication and mention of the grant of the patent: **22.03.2023**
(21) Application number: 20714084.9
(22) Date of filing: 04.03.2020
(51) Int. Cl.: C08G 18/12, C08G 18/28, C08G 18/79, H01L 23/373, C08G 18/32, C08G 18/48, C08L 75/08

(54) **POLYURETHANE BASED THERMAL INTERFACE MATERIAL**
THERMISCHES INTERFACE-MATERIAL AUF POLYURETHANBASIS
MATÉRIAU D'INTERFACE THERMIQUE À BASE DE POLYURÉTHANE

(30) Priority: 05.04.2019 US 201962829817 P
(43) Date of publication of application: 09.02.2022
(73) Proprietor: DDP Specialty Electronic Materials US, LLC, Wilmington, DE 19805 (US)
(72) Inventor: GRUNDER, Sergio, 8807 Freienbach (CH); ARDIZZONE, Filippo, 8807 Freienbach (CH); LUTZ, Andreas, 8807 Freienbach (CH); HILLESHEIM, Nina, 8807 Freienbach (CH)
(74) Representative: Heinemann, Monica
(86) International application number: PCT/US2020/020892
(87) International publication number: WO 2020/205137

(56) References cited:
- EP-A1- 0 093 392
- EP-A1- 2 546 872
- WO-A1-89/12654
- JP-A- 2002 015 843
- US-A- 4 066 578

## Description

### FIELD OF DISCLOSURE

The disclosure relates to thermal interface materials and their use in battery powered vehicles.

### BACKGROUND

Compared to traditional modes of travel, battery powered vehicles offer significant advantages, such as light weight, reduced CO₂ emission, etc. However, to ensure optimal use of the technology, a number of technological problems still need to be overcome. For example, one current effort in the industry is to increase the driving range of battery powered vehicles by developing batteries with higher density. And this leads to the need to develop better thermal management systems for high density batteries.

In battery powered vehicles, battery cells or modules are thermally connected to cooling units by thermal interface materials (TIM). Such TIM are typically formed of polymeric materials filled with thermally conductive fillers. To achieve a thermal conductivity of 2 W/m·K or higher, fillers with thermal conductivity of 100 W/m K or higher, such as boron nitrides or aluminum powders, may be used. However, such fillers are expensive and abrasive. A cheaper and non-abrasive alternative is aluminum trihydroxide (ATH). Due to its lower thermal conductivity of about 10 W/m·K, high loadings of ATH (i.e., 80 wt% or higher) are needed. And for the ease of application, liquid based polymeric binders (e.g., polyols) are typically used. It is found, thought, such TIM (liquid binder filled with high loading of ATH) tends to fail aging tests, that is, cracks are formed after exposure to climate change conditions.

Therefore, there is still a need to develop TIM that are highly thermally conductive, cost effective, easy to apply, and weather resistant.

### SUMMARY

Provided herein is a thermal interface material composition comprising: a) a urethane based binder component, which comprises at least one non-reactive polyurethane prepolymer, and b) about 80-95 wt% of aluminum trihydroxide, with the total weight of the composition totaling to 100 wt%, and wherein, the at least one non-reactive polyurethane prepolymer, i) is a reaction product of at least one polyisocyanate and at least one aliphatic monol, ii) is substantially free of residual isocyanate groups; and iii) has an average molecular weight of 2,000-50,000 g/mol, and wherein, if polyol based material is present in the composition, the content level of the polyol based material is less than the total content level of the urethane based binder component.

In one embodiment of the thermal interface material composition, the urethane based binder component is present at a level of about 2-20 wt%, based on the total weight of the composition.

In a further embodiment of the thermal interface material composition, the at least one non-reactive polyurethane prepolymer contains less than about 0.8 wt% of the residual isocyanate groups, based on the weight of the at least one non-reactive polyurethane prepolymer.

In a yet further embodiment of the thermal interface material composition, the at least one non-reactive polyurethane prepolymer is a reaction product of at least one aliphatic polyisocyanate and the at least one aliphatic mono!.

In a yet further embodiment of the thermal interface material composition, the at least one aliphatic polyisocyanate is a prepolymer based on multifunctional isocyanates selected from the group consisting of ethylene diisocyanate; hexamethylene-1,6-diisocyanate (HDI); isophorone diisocyanate (IPDI); 4,4'-, 2,2'- and 2,4'-dicyclohexylmethane diisocyanate (H12MDI); norbornene diisocyanate; 1,3- and 1,4-(bisisocyanatomethyl)cyclohexane (including cis- or trans-isomers thereof); tetramethylene-1,4-diisocyanate (TMXDI); 1,12-dodecane diisocyanate; 2,2,4-trimethylhexamethylene diisocyanate; and combinations of two or more thereof.

In a yet further embodiment of the thermal interface material composition, the at least one aliphatic polyisocyanate is a prepolymer based on hexamethylene-1,6-diisocyanate (HDI).

In a yet further embodiment of the thermal interface material composition, the urethane based binder component optionally further comprises at least one other polyurethane that is distinct from the non-reactive polyurethane prepolymer, and wherein, the weight ratio between the at least one non-reactive polyurethane prepolymer and the at least one other polyurethane ranges from about 100:0-15:85.

In a yet further embodiment of the thermal interface material composition, the aluminum trihydroxide has an average particle size ranging from about 5-100 µm.

In a yet further embodiment of the thermal interface material composition, the aluminum trihydroxide has a multi-modal particle size distribution.

Further provided herein is an article comprising the thermal interface material composition described above.

In one embodiment, the article further comprises a battery module that is formed of one or more battery cells and a cooling unit, wherein, the battery module is connected to the cooling unit via the thermal interface material composition.

### DETAILED DESCRIPTION

Disclosed herein are thermal interface materials (TIM) comprising: a) a urethane based binder component, which comprises at least one non-reactive polyurethane prepolymer, and b) about 80-95 wt% of aluminum trihydroxide (ATH), with the total weight of the composition totaling to 100 wt%, provided that if polyol based material is present in the composition, the content level of the polyol based material is less than the total content level of the urethane based binder component.

The non-reactive polyurethane prepolymers used herein are the reaction products of at least one polyisocyanate and at least one aliphatic monol. The non-reactive polyurethane prepolymers used herein have a molecular weight ranging from about 2,000-50,000 g/mol, or from about 3,000-30,000 g/mol, or from about 4,000-15,000 g/mol. In addition, the non-reactive polyurethane prepolymers used herein are substantially free of residual isocyanate groups, that is there are less than about 0.8 wt% or less than about 0.4 wt% of residual isocyanate groups in the prepolymer.

In accordance with the present disclosure, the polyisocyanates used herein are prepolymers based on multifunctional isocyanates (e.g., diisocyanates and triisocyanates) and may be aliphatic, alicyclic, or aromatic polyisocyanates. Exemplary multifunctional isocyanates used herein include, without limitation, ethylene diisocyanate; hexamethylene-1,6-diisocyanate (HDI); isophorone diisocyanate (IPDI); 4,4'-, 2,2'- and 2,4'-dicyclohexylmethane diisocyanate (H₁₂MDI); norbornene diisocyanate; 1,3- and 1,4-(bisisocyanatomethyl)cyclohexane (including cis- or trans-isomers thereof); tetramethylene-1,4-diisocyanate (TMXDI); 1,12-dodecane diisocyanate; 2,2,4-trimethylhexamethylene diisocyanate; 2,2'-, 2,4'- and 4,4'-methyldiphenyl diisocyanate (MDI); carbodiimide modified MDI; 2,4- and 2,6-toluene diisocyanate (TDI); 1,3- and 1,4-phenylene diisocyanate; 1,5-naphthylene diisocyanate; triphenylmethane-4,4',4"-triisocyanate; polyphenylpolymethylene polyisocyanates.

In one embodiment, the multifunctional isocyanates used herein are aliphatic isocyanates. In a further embodiment, the multifunctional isocyanates used herein are selected from hexamethylene-1,6-diisocyanate; isophorone diisocyanate; 1,3-(bisisocyanatomethyl) cyclohexane; 1,4-(bisisocyanatomethyl)cyclohexane; or a mixture of two or more thereof. In a yet further embodiment, the multifunctional isocyanate used herein is hexamethylene-1,6-diisocyanate.

The polyisocyanates may have a percent NCO amount of up to about 25%, or up to about 15%, or up to about 10%. For example, the percent NCO amount may range from about 1-10%, or from about 3-8%. In certain embodiments, the polyisocyanates used herein may have an average isocyanate functionality of at least about 2.0, or at least about 2.2, or at least about 2.4; and no greater than about 4, or no greater than about 3.5, or no greater than about 3.0. In a further embodiment, the equivalent weight of the polyisocyanate may be at least about 100, or at least about 110, or at least about 120; and may be no greater than about 300, or no greater than about 250, or no greater than about 200.

The aliphatic monols used herein may have a molecular weight of about 200-5,000 g/mol, or about 300-3,000 g/mol, or about 500-2,000 g/mol.

Along with the polyisocyanates and the aliphatic monols, additional additives also may be added when preparing the non-reactive polyurethane prepolymers. These include catalysts, chain extenders, crosslinkers, fillers, moisture scavengers, colorants.

In particular, a number of aliphatic and aromatic amines (e.g., diaminobicyclooctane-DABCO), organometallic compounds (e.g., dibutyltin dilaurate, dibutyltin diacetate), alkali metal salts of carboxylic acids and phenols (calcium, magnesium, strontium, barium, salts of hexanoic, octanoic, naphthenic, linolenic acid) may be used as catalysts.

Additionally, to obtain the non-reactive polyurethane prepolymers substantially free of residual isocyanate groups, excessive stoichiometric amount of the aliphatic monols needs to be used in the reaction, that is the ratio between -OH groups in the aliphatic monols to -NCO groups in the polyisocyanates is greater than 1. The preparation of the non-reactive polyurethane prepolymers include: mixing the at least one polyisocyanates, the at least one aliphatic monols, and other additives, such as catalysts, together; stirring the reaction mixture under an atmosphere of nitrogen or under vacuum at about 20-80°C for about 10-60 min; cooling the reaction product to room temperature; and placing and storing the reaction product in a sealed container.

The urethane based binder component may be formed of one or more non-reactive polyurethane prepolymers as described above. Additionally, the urethane based binder component may optionally further comprise other suitable polyurethanes that are distinct from the non-reactive polyurethane prepolymers described above. Within the urethane based component, the weight ratio between the one or more non-reactive polyurethane prepolymer(s) and the optional other polyurethane(s) may range from about 100:0-15:85, or from about 100:0-20:80, or from about 100:0-25:75.

In accordance with the present disclosure, the urethane based binder component may be present in the TIM at a level of about 2-20 wt%, or about 3-15 wt%, or about 5-15 wt%, based on the total weight of the TIM composition.

The ATH used herein may be monomodal ATH powders or ATH powders having a multi-modal particle size distribution (e.g., bi-modal, trimodal).

When monomodal ATH powders are used, the average particle size may range from about 5-100 µm. And when multi-modal ATH powders are used, the average particle size of the smallest particles may be less than about 10 µm, while the average particle size of the largest particles may be greater than about 50 µm. Additionally, the ATH powders used herein also may be surface treated with silane, titanate, carboxylates.

In accordance with the present disclosure, the ATH powders may be present in the composition at a level of about 80-95 wt% or about 80-92 wt%, based on the total weight of the TIM composition.

In addition, up to about 10 wt%, or about 1-10 wt%, or about 2-7 wt%, or about 2-5 wt%, of precipitated calcium carbonate may be added into the TIM composition. Without being bound by any particular theory, it is believed that the addition of the optional precipitated calcium carbonate may improve the anti-settling of the ATH.

Furthermore, the TIM compositions disclosed herein may optionally further comprise other suitable additives, such as, catalysts, plasticizers, stabilizers, adhesion promoters, fillers, colorants.

Such optional additives may be present at a level of up to about 10 wt%, or up to about 8 wt%, or up to about 5 wt%, based on the total weight of the TIM.

As demonstrated below by the examples, by incorporating high loading of ATH fillers in non-reactive polyurethane prepolymers, the TIM as such obtained possess high thermal conductivity (e.g., 2 W/m·K or higher) and improved weather resistance.

Further disclosed herein are battery pack systems in which a cooling unit or plate is coupled to a battery module (formed of one or more battery cells) via the TIM described above such that heat can be conducted therebetween. In one embodiment, the battery pack systems are those used in battery powered vehicles.

### EXAMPLES

### Materials

• PU-Pre - Methylene diphenyl diisocyanate (MDI) based urethane prepolymer, having a density of 1.040 g/ml and viscosity (dynamic) of 1500 mPa-s;
• Polyisocyanate - Hexamethylene-1,6-diisocyanate (HDI) homopolymer (HDI trimer) obtained from Covestro;
• Monol - C₁₂-C₁₄ fatty alcohol initiated fully propoxylated (with propyleneoxide) monol (MW 935 g/mol, OH-number: 60.4, equivalent weight: 927) obtained from DowDuPont;
• Polyol-1 - polypropyleneoxide polyol (functionality: 2, MW: 1000 g/mol) obtained from DowDuPont under the tradename Voranol^{®} 1010L;
• Polyol-2 - glycerin initiated ethylene oxide based propoxylated triol (MW: 1800 g/mol, OH number: 35 KOH/g) obtained from DowDuPont under the tradename Voranol^{®} CP4610;
• ATH - bimodally distributed aluminum trihydroxide, with the average particle size of the small particles less than 10 µm and the average particle size of the large particles greater than 50 µm;
• CaCO₃ - precipitated calcium carbonate;
• Catalyst-1 - dibutyltin dilaurate (DBTDL) obtained from Evonik under the trade name DABCO^{™} T-12;
• Catalyst-2 - dimethyltin dineodecanoateobtained from Momentive under the trade name Fomrez^{™} UL28;
• Fatty acid - methyl ester of unsaturated C₁₆-C₁₈ fatty acid;
• Plasticizer - di-C₈-C₁₀ alkyl esters of 1,2-benzenecarboxylic acid;
• DINP - di-isononyl phthalate obtained from Evonik under the trade name Vestinol^{™} 9;
• Silane - hexadecyltrimethoxysilane;
• PU (non-reactive) - non-reactive polyurethane prepolymer with the following formulation and properties (Table 1) were prepared by 1) mixing Polyisocyanate and Monol in a reactor and raising the temperature to 60°C; 2) adding Catalyst-1 into the reaction mixture; 3) stirring the mixture at 80°C for 45 min under an atmosphere of nitrogen followed by 10 min under vacuum; and 4) cooling the reaction product to room temperature and transferring into a sealed container.

**TABLE 1**

| **PU (non-reactive)** | |
|---|---|
| **Formulation** | |
| Monol (wt%) | 82.74 |
| Polyisocyanate (wt%) | 17.21 |
| Catalyst-1 (wt%) | 0.05 |

| **Properties** | |
|---|---|
| Viscosity (45°C, CP4/20, up/down Newtonian) (Pa·s) | 1 |
| NCO (%) | 0 |
| GPC MW | 5000 |
| GPC POI | 1.3 |

• PU - polyurethane with the following formulation and properties (Table 2) were prepared by 1) mixing PU-Pre, Polyol-2, and 1,4-butanediol in a reactor and raising the temperature to 60°C; 2) dissolving Catalyst-2 in DINP and adding dissolved Catalyst-2 into the reaction mixture; 3) stirring the mixture at 80°C for 45 min under an atmosphere of nitrogen followed by 10 min under vacuum; and 4) cooling the reaction product to room temperature and transferring into a sealed container.

**TABLE 2**

| **PU** | |
|---|---|
| **Formulation** | |
| Polyol-2 (wt%) | 55.25 |
| 1,4-butanediol (wt%) | 22 |
| PU-Pre | 22 |
| DINP (wt%) | 0.727 |
| Catalyst-2 (wt%) | 0.023 |

| **Properties** | |
|---|---|
| Viscosity (45°C, CP4/20, up/down Newtonian) (Pa·s) | 4 |
| NCO (%) | 0 |
| GPC MW | 125000 |

### Methods

### Sample Preparation

In each of the Comparative Examples CE1-CE13 and Examples E1-E14, all components as listed in Table 3 or Table 4 (first liquid components, then solid components) were added in a planetary mixer or a dual asymmetric centrifuge, mixed for about 30 min under vacuum, and the resulting TIM (in paste form) was then transferred into cartridges, pails, or drums for storage.

### Press-in Force

The press-in force for the TIM paste in each sample was measured using a tensiometer (Zwick). The TIM paste from each sample were placed on a metal surface. An aluminum piston with 40 mm diameter was placed on top of the sample paste and the sample paste was compressed to 5 mm (initial thickness). The sample paste was then further compressed to a thickness of 0.3 mm with 1 mm/s velocity and the force deflection curve was recorded. The force (N) at 0.5 mm thickness was recorded as the press-in force.

### Thermal Conductivity

The thermal conductivity for the TIM paste obtained in each sample was measured according to ASTM 5470, using a TIM tester from ZFW Stuttgart. The measurement was performed in Spaltplus mode between 1.8-1.2 mm thickness and the absolute thermal conductivity λ (W/m·K) was recorded.

### Resistivity

The TIM paste obtained in each sample was formed into 2.0 mm thick plaques and the specific volume resistance (Ω.cm) was measured using these plaques at 100 V and 23°C in accordance with DIN IEC 93 / VDE 0303 / HD 429 S1.

### Cyclic Bleeding Tests

For each sample, sandwich panels configured as "e-coated steel substrates/TIM/glass" were prepared. The e-coated steel substrates were cleaned with isopropanol before TIM paste was applied thereon. The TIM paste was then compressed with the glass substrate to 3.0 mm (thickness adjusted with spacer) to form 60 mm diameter test samples. The test samples were then exposed to climate change conditions, in which each cycle took 12 hours to complete and consisted of 4 hours at -40°C (non-controlled humidity), 4 hours to adjust temperature to 80°C, and 4 hours at 80°C with 80 w% relative humidity. The sandwich panels were then visually inspected after climate conditioning and samples with no crack formation, no phase separation, and no sliding were rated as "ok" and otherwise rated "Nok".

As demonstrated by Comparative Example CE1-CE2 and CE4-CE10 (Table 3), when high loading of ATH (82-87 wt%) was added into polyol based binder, the resulting TIM pastes all failed both cyclic bleeding tests (except CE3, which passed the 1w cyclic bleeding test but failed the 2s cyclic bleeding test). Also, in CE11-CE13 (Table 3), when the binder material was changed to aromatic polyurethane (CE11) or non-reactive polyurethane prepolymer in combination with high level of polyol (CE12-CE13), the resulting TIM paste also failed both cyclic bleeding tests.

While as demonstrated by Examples E1-E14 (Table 4), when high loading of ATH (82-91 wt%) was incorporated into non-reactive polyurethane prepolymer based binder, the resulting TIM pastes maintained high thermal conductivity and passed both cyclic bleeding tests (except E9, which only passed the 1w cyclic bleeding test).

**Table 3**

| | CE1 | CE2 | CE3 | CE4 | CE5 | CE6 | CE7 | CE8 | CE9 | CE10 | CE11 | CE12 | CE13 |
|---|---|---|---|---|---|---|---|---|---|---|---|---|---|
| Compositions (wt%) | | | | | | | | | | | | | |
| PU (non-reactive) | - | - | - | - | - | - | - | - | - | - | - | 2.5 | 2.5 |
| PU | - | - | - | - | - | - | - | - | - | - | 10.9 | - | - |
| Polyol | 12 | 10 | 8 | 10.9 | 8.9 | 6.9 | 9.9 | 7.9 | 5.9 | 10.9 | - | 7 | 8 |
| PU-Pre | - | - | - | 1 | 1 | 1 | 2 | 2 | 2 | 1 | 1 | 1 | - |
| ATH | 87 | 87 | 87 | 87 | 87 | 87 | 87 | 87 | 87 | 82 | 87 | 83.5 | 83.5 |
| CaCO₃ | - | - | - | - | - | - | - | - | - | 5 | - | 3 | 3 |
| Dioctyltin dineodecanoate | - | - | - | 0.1 | 0.1 | 0.1 | 0.1 | 0.1 | 0.1 | 0.1 | 0.1 | - | - |
| Fatty acid | - | 2 | 4 | - | 2 | 4 | - | 2 | 4 | - | - | 2 | 2 |
| Plasticizer | - | - | - | - | - | - | - | - | - | - | - | - | - |
| Silane | 1 | 1 | 1 | 1 | 1 | 1 | 1 | 1 | 1 | 1 | 1 | 1 | 1 |

| Properties | | | | | | | | | | | | | |
|---|---|---|---|---|---|---|---|---|---|---|---|---|---|
| Thermal Conductivity A (W/mK) | n/d | n/d | n/d | 2.60 | n/d | n/d | n/d | n/d | n/d | n/d | n/d | n/d | n/d |
| Press-in Force at 0.5 mm (N) | 128 | 79 | 52 | 414 | 274 | 111 | 682 | 319 | 183 | 453 | 872 | 361 | 194 |
| cyclic bleeding test 1w climate change | Nok | Nok | Ok | Nok | Nok | Nok | Nok | Nok | Nok | Nok | Nok | Nok | Nok |
| cyclic bleeding test 2w climate change | Nok | Nok | Nok | Nok | Nok | Nok | Nok | Nok | Nok | Nok | Nok | Nok | Nok |
| Specific volume resistivity (Ω.cm) | n/d | n/d | n/d | 1×10⁹ | n/d | n/d | 5×10⁹ | n/d | n/d | n/d | 1×10⁹ | 2×10⁹ | 1×10⁹ |

| | | | | | | | | | | | | | |
|---|---|---|---|---|---|---|---|---|---|---|---|---|---|
| Note: n/d denotes not determined. | | | | | | | | | | | | | |

**Table 4**

| | E1 | E2 | E3 | E4 | E5 | E6 | E7 | E8 | E9 | E10 | E11 | E12 | E13 | E14 |
|---|---|---|---|---|---|---|---|---|---|---|---|---|---|---|
| Composition (wt%) | | | | | | | | | | | | | | |
| PU (non-reactive) | 2.5 | 10 | 2 | 2.5 | 0.78 | 2.5 | 1.67 | 2.5 | 7 | 6.5 | 5.5 | 4.5 | 3.5 | 3 |
| PU | 7 | - | - | 7 | 2.22 | 7 | 4.6 | 7 | 2.5 | 3 | 4 | 5 | 6 | 7 |
| ATH | 87 | 87 | 91 | 83.5 | 88 | 84 | 85.73 | 82 | 82 | 82 | 82 | 82 | 82 | 82 |
| CaCO₃ | - | - | - | 3 | 3 | 3 | 3 | 3 | 3 | 3 | 3 | 3 | 3 | 3 |
| Fatty acid | 2.5 | 2 | 6 | 3 | 5 | 2.5 | 4 | - | - | - | - | - | - | - |
| Plasticizer | - | - | - | - | - | - | - | 5.5 | 5.5 | 5.5 | 5.5 | 5.5 | 5.5 | 5.5 |
| Silane | 1 | 1 | 1 | 1 | 1 | 1 | 1 | - | - | - | - | - | - | - |

| Properties | | | | | | | | | | | | | | |
|---|---|---|---|---|---|---|---|---|---|---|---|---|---|---|
| Thermal Conductivity A (W/mK) | n/d | n/d | n/d | 2.46 | 3.24 | 2.41 | 2.92 | n/d | 2.25 | 2.18 | n/d | n/d | n/d | n/d |
| Press-in Force at 0.5 mm (N) | 170 | 217 | 99 | 223 | 375 | 372 | 296 | 552 | 496 | 659 | 598 | 517 | 506 | 440 |
| cyclic bleeding test 1w climate change | ok | ok | ok | ok | ok | ok | ok | ok | ok | ok | ok | ok | ok | ok |
| cyclic bleeding test 2w climate change | ok | ok | ok | ok | ok | ok | ok | ok | Nok | ok | ok | ok | ok | ok |
| Specific volume resistivity (Ω.cm) | 7x10⁷ | 4x10⁹ | n/d | 5x10⁸ | 1x10⁸ | 2x10⁸ | n/d | 4x10⁹ | 1X10¹⁰ | 1X10¹⁰ | 1X10⁹ | 7X10⁸ | 7X10⁸ | 3X10⁹ |

| | | | | | | | | | | | | | | |
|---|---|---|---|---|---|---|---|---|---|---|---|---|---|---|
| Note: n/d denotes not determined. | | | | | | | | | | | | | | |

## Claims

1. A thermal interface material composition comprising:
a) a urethane based binder component, which comprises at least one non-reactive polyurethane prepolymer, and
b) about 80-95 wt% of aluminum trihydroxide,
with the total weight of the composition totaling to 100 wt%, wherein, the at least one non-reactive polyurethane prepolymer, i) is a reaction product of at least one polyisocyanate and at least one aliphatic monol, ii) is substantially free of residual isocyanate groups; and iii) has an average molecular weight of 2,000-50,000 g/mol,
and wherein, if polyol based material is present in the composition, the content level of the polyol based material is less than the total content level of the urethane based binder component.

2. The thermal interface material composition of Claim 1, wherein, the urethane based binder component is present at a level of about 2-20 wt%, based on the total weight of the composition.

3. The thermal interface material composition of Claim 1, wherein, the at least one non-reactive polyurethane prepolymer contains less than about 0.8 wt% of the residual isocyanate groups, based on the weight of the at least one non-reactive polyurethane prepolymer.

4. The thermal interface material composition of Claim 1, wherein, the at least one non-reactive polyurethane prepolymer is a reaction product of at least one aliphatic polyisocyanate and the at least one aliphatic monol.

5. The thermal interface material composition of Claim 4, wherein, the at least one aliphatic polyisocyanate is a prepolymer based on multifunctional isocyanates selected from the group consisting of ethylene diisocyanate; hexamethylene-1,6-diisocyanate (HDI); isophorone diisocyanate (IPDI); 4,4'-, 2,2'- and 2,4'-dicyclohexylmethane diisocyanate (H₁₂MDI); norbornene diisocyanate; 1,3- and 1,4-(bisisocyanatomethyl)cyclohexane (including cis- or trans-isomers thereof); tetramethylene-1,4-diisocyanate (TMXDI); 1,12-dodecane diisocyanate; 2,2,4-trimethylhexamethylene diisocyanate; and combinations of two or more thereof.

6. The thermal interface material composition of Claim 5, wherein, the at least one aliphatic polyisocyanate is a prepolymer based on hexamethylene-1,6-diisocyanate (HDI).

7. The thermal interface material composition of Claim 2, wherein, the urethane based binder component optionally further comprises at least one other polyurethane that is distinct from the non-reactive polyurethane prepolymer, and wherein, the weight ratio between the at least one non-reactive polyurethane prepolymer and the at least one other polyurethane ranges from about 100:0-15:85.

8. The thermal interface material composition of Claim 1, wherein, the aluminum trihydroxide has an average particle size ranging from about 5-100 µm.

9. The thermal interface material composition of Claim 8, wherein, the aluminum trihydroxide has a multi-modal particle size distribution.

10. An article comprising the thermal interface material composition recited in Claim 1.

11. The article of Claim 10, which further comprises a battery module that is formed of one or more battery cells and a cooling unit, wherein, the battery module is connected to the cooling unit via the thermal interface material composition.

## Patentansprüche

1. Zusammensetzung aus thermischem Interface-Material, umfassend:
a) eine Bindemittelkomponente auf Urethanbasis, die mindestens ein nichtreaktives Polyurethanvorpolymer umfasst, und
b) etwa 80-95 Gew.-% Aluminiumtrihydroxid,
wobei das Gesamtgewicht der Zusammensetzung insgesamt 100 Gew.-% beträgt,
wobei das mindestens eine nichtreaktive Polyurethanvorpolymer i) ein Reaktionsprodukt mindestens eines Polyisocyanats und mindestens eines aliphatischen Monols ist, ii) im Wesentlichen frei von restlichen Isocyanatgruppen ist und iii) ein durchschnittliches Molekulargewicht von 2 000-50 000 g/Mol aufweist,
und wobei, wenn Material auf Polyolbasis in der Zusammensetzung vorliegt, das Gehaltsniveau des Materials auf Polyolbasis geringer ist als das Gesamtgehaltsniveau der Bindemittelkomponente auf Urethanbasis beträgt.

2. Zusammensetzung aus thermischem Interface-Material nach Anspruch 1, wobei die Bindemittelkomponente auf Urethanbasis auf einem Niveau von etwa 2-20 Gew.-%, auf das Gesamtgewicht der Zusammensetzung bezogen, vorliegt.

3. Zusammensetzung aus thermischem Interface-Material nach Anspruch 1, wobei das mindestens eine nichtreaktive Polyurethanvorpolymer weniger als etwa 0,8 Gew.-% der restlichen Isocyanatgruppen, auf das Gewicht des mindestens einen nichtreaktiven Polyurethanvorpolymers bezogen, enthält.

4. Zusammensetzung aus thermischem Interface-Material nach Anspruch 1, wobei das mindestens eine nichtreaktive Polyurethanvorpolymer ein Reaktionsprodukt von mindestens einem aliphatischen Polyisocyanat und dem mindestens einen aliphatischen Monol ist.

5. Zusammensetzung aus thermischem Interface-Material nach Anspruch 4, wobei das mindestens eine aliphatische Polyisocyanat ein Vorpolymer auf der Basis von multifunktionellen Isocyanaten ist, ausgewählt aus der Gruppe bestehend aus Ethylendiisocyanat, Hexamethylen-1,6-diisocyanat (HDI), Isophorondiisocyanat (IPDI), 4,4'-, 2,2'- und 2,4'-Dicyclohexylmethandiisocyanat (H₁₂MDI), Norbornendiisocyanat, 1,3- und 1,4-(Bisisocyanatmethyl)cyclohexan (einschließlich cis- oder trans-Isomeren davon), Tetramethylen-1,4-diisocyanat (TMXDI), 1,12-Dodecandiisocyanat, 2,2,4-Trimethylhexamethylendiisocyanat und Kombinationen von zwei oder mehreren davon.

6. Zusammensetzung aus thermischem Interface-Material nach Anspruch 5, wobei das mindestens eine aliphatische Polyisocyanat ein Vorpolymer auf der Basis von Hexamethylen-1,6-diisocyanat (HDI) ist.

7. Zusammensetzung aus thermischem Interface-Material nach Anspruch 2, wobei die Bindemittelkomponente auf Urethanbasis wahlweise ferner mindestens ein anderes Polyurethan umfasst, das von dem nichtreaktiven Polyurethanvorpolymer verschieden ist, und wobei das Gewichtsverhältnis zwischen dem mindestens einen nichtreaktiven Polyurethanvorpolymer und dem mindestens einen anderen Polyurethan im Bereich von etwa 100:0-15:85 liegt.

8. Zusammensetzung aus thermischem Interface-Material nach Anspruch 1, wobei das Aluminiumtrihydroxid eine durchschnittliche Teilchengröße im Bereich von etwa 5-100 µm aufweist.

9. Zusammensetzung aus thermischem Interface-Material nach Anspruch 8, wobei das Aluminiumtrihydroxid eine multimodale Teilchengrößenverteilung aufweist.

10. Artikel umfassend die Zusammensetzung aus thermischem Interface-Material, die in Anspruch 1 aufgeführt ist.

11. Artikel nach Anspruch 10, der ferner ein Batteriemodul umfasst, das aus einer oder mehreren Batteriezellen und einer Kühleinheit gebildet ist, wobei das Batteriemodul mit der Kühleinheit über die Zusammensetzung aus thermischem Interface-Material verbunden ist.

## Revendications

1. Composition de matériau d'interface thermique comprenant :
a) un constituant liant à base d'uréthane, qui comprend au moins un prépolymère de polyuréthane non réactif, et
b) environ 80 à 95 % en pds de trihydroxyde d'aluminium,
le poids total de la composition totalisant 100 % en pds,
dans laquelle, l'au moins un prépolymère de polyuréthane non réactif, i) est un produit réactionnel d'au moins un polyisocyanate et d'au moins un monol aliphatique, ii) est sensiblement exempt de groupes isocyanates résiduels, et iii) présente un poids moléculaire moyen de 2 000 à 50 000 g/mole,
et dans laquelle, si un matériau à base de polyol est présent dans la composition, le niveau de la teneur du matériau à base de polyol est inférieur au niveau de la teneur totale du constituant liant à base d'uréthane.

2. Composition de matériau d'interface thermique selon la revendication 1, dans laquelle, le constituant liant à base d'uréthane est présent à un niveau d'environ 2 à 20 % en pds, sur la base du poids total de la composition.

3. Composition de matériau d'interface thermique selon la revendication 1, dans laquelle, l'au moins un prépolymère de polyuréthane non réactif contient moins qu'environ 0,8 % en pds de groupes isocyanates résiduels, sur la base du poids du au moins un prépolymère de polyuréthane non réactif.

4. Composition de matériau d'interface thermique selon la revendication 1, dans laquelle, l'au moins un prépolymère de polyuréthane non réactif est un produit réactionnel d'au moins un polyisocyanate aliphatique et du au moins un monol aliphatique.

5. Composition de matériau d'interface thermique selon la revendication 4, dans laquelle, l'au moins un polyisocyanate aliphatique est un prépolymère à base d'isocyanates multifonctionnels sélectionnés dans le groupe constitué du diisocyanate d'éthylène; du 1,6-diisocyanate d'hexaméthylène (HDI); du diisocyanate d'isophorone (IPDI); du diisocyanate de 4,4'-, 2,2'- et 2,4'-dicyclohexylméthane (H₁₂MDI); du diisocyanate de norbornène; du 1,3- et 1,4-(bisisocyanatométhyl)cyclohexane (incluant ses isomères *cis-* ou *trans*-); du 1,4-diisocyanate de tétraméthylène (TMXDI); du diisocyanate de 1,12-dodécane; du diisocyanate de 2,2,4-triméthylhexaméthylène; et des combinaisons de deux ou plusieurs de ceux-ci.

6. Composition de matériau d'interface thermique selon la revendication 5, dans laquelle, l'au moins un polyisocyanate aliphatique est un prépolymère à base de 1,6-diisocyanate d'hexaméthylène (HDI).

7. Composition de matériau d'interface thermique selon la revendication 2, dans laquelle, le constituant liant à base d'uréthane comprend en outre facultativement au moins un autre polyuréthane qui est distinct du prépolymère de polyuréthane non réactif, et dans laquelle, le rapport en poids entre l'au moins un prépolymère de polyuréthane non réactif et l'au moins un autre polyuréthane varie entre environ 100:0 à 15:85.

8. Composition de matériau d'interface thermique selon la revendication 1, dans laquelle, le trihydroxyde d'aluminium présente une taille moyenne de particule qui varie entre environ 5 à 100 µm.

9. Composition de matériau d'interface thermique selon la revendication 8, dans laquelle, le trihydroxyde d'aluminium présente une distribution multimodale de tailles de particules.

10. Article comprenant la composition de matériau d'interface thermique énoncée selon la revendication 1.

11. Article selon la revendication 10, qui comprend en outre un module de batterie qui est formé d'une ou de plusieurs éléments de batterie et d'une unité de refroidissement, dans lequel, le module de batterie est branché à l'unité de refroidissement par l'intermédiaire de la composition de matériau d'interface thermique.
